# EUROPEAN PATENT APPLICATION

(11) **EP 4 703 862 A1**
(43) Date of publication of application: **04.03.2026**
(21) Application number: 25187781.7
(22) Date of filing: 07.07.2025
(51) Int. Cl.: G06F 3/06, G06F 12/02

(54) **MEMORY CONTROLLER, STORAGE DEVICE INCLUDING THE SAME AND NONVOLATILE MEMORY DEVICE**

(30) Priority: 03.09.2024 KR 20240119140
(71) Applicant: SAMSUNG ELECTRONICS CO., LTD., Yeongtong-gu Suwon-si, Gyeonggi-do 16677 (KR)
(72) Inventor: SHIN, Seo-Hyun, 16677 Suwon-si, Gyeonggi-do (KR); LEE, Kyung Duk, 16677 Suwon-si, Gyeonggi-do (KR)
(74) Representative: Kuhnen & Wacker Patent- und Rechtsanwaltsbüro PartG mbB

(57) **Abstract**

A memory controller, a storage device, a method for operating memory controller and a nonvolatile memory device are provided. The memory controller includes a processing circuit configured to control a memory device including a plurality of data blocks, wherein the processing circuit is further configured to classify a first portion of the plurality of data blocks into a first group; classify a second portion of the plurality of data blocks into a second group, the second portion being different from the first portion; determine, based on environment information, first setting data to be used for sensing data blocks included in the first group; determine, based on the environment information, second setting data to be used for sensing data blocks included in the second group; and store initialization information on the determined first setting data and second setting data in the memory device.

## Description

### BACKGROUND

One or more example embodiments of the disclosure relate to a memory controller, a storage device including the same, and a nonvolatile memory device.

A storage device including a solid state drive (SSD) or the like includes a memory device that stores data, and a memory controller that controls an overall operation of the memory device.

Setting data is information required for an initialization process before initial driving of the memory device. During an initial driving (booting) of the storage device, a setting operation of loading setting data to set the memory device may be performed such that a nonvolatile memory device may operate normally.

With the development of technology, users' needs for storage devices are becoming more diverse, and research on how to quickly boot storage devices while accepting users' various needs is ongoing.

### SUMMARY

One or more example embodiments of the disclosure provide a memory controller that may allow a memory device to adaptively apply several setting data in accordance with characteristics of a group.

One or more example embodiments of the disclosure provide a storage device used to adaptively apply several setting data in accordance with characteristics of a group.

Other object of the disclosure is to provide a nonvolatile memory device used to adaptively apply several setting data in accordance with characteristics of a group.

According to an aspect of an example embodiment of the disclosure, there is provided a memory controller including a processing circuit configured to control a memory device including a plurality of data blocks, wherein the processing circuit is further configured to: classify a first portion of the plurality of data blocks into a first group; classify a second portion of the plurality of data blocks into a second group, the second portion being different from the first portion; determine, based on environment information, first setting data to be used for sensing data blocks included in the first group; determine, based on the environment information, second setting data to be used for sensing data blocks included in the second group; and store initialization information on the determined first setting data and second setting data in the memory device.

According to an aspect of an example embodiment of the disclosure, there is provided a storage device including: a memory device including data blocks belonging to a first group and data blocks belonging to a second group, and a memory controller configured to control the memory device, wherein the memory controller is further configured to: determine, based on environment information, first setting data including a first sensing condition to be used for sensing the data blocks belonging to the first group; determine, based on the environment information, second setting data including a second sensing condition to be used for sensing the data blocks belonging to the second group; and provide initialization information on the determined first setting data and second setting data to the memory device, and wherein the memory device is configured to: perform a setting operation in response to an initialization command of the memory controller; sense the data blocks belonging to the first group under the first sensing condition based on the initialization information; and sense the data blocks belonging to the second group under the second sensing condition based on the initialization information.

According to an aspect of an example embodiment of the disclosure, there is provided a method of operating a memory controller, the method including: classifying, by the memory controller, a plurality of data blocks included in a memory device into a first group and a second group; based on environment information, determining, by the memory controller, first setting data to be used for sensing the data blocks belonging to the first group; based on the environment information, determining, by the memory controller, second setting data to be used for sensing the data blocks belonging to the second group; and providing, by the memory controller, initialization information on the first setting data and the second setting data determined for each group, to the memory device.

According to an aspect of an example embodiment of the disclosure, there is provided a nonvolatile memory device, the nonvolatile memory device including: a memory cell array including a first memory plane having a first data block and a second memory plane having a second data block; and a control logic circuit configured to write or read in or from the memory cell array, wherein the memory cell array stores first initialization information for determining setting data including a sensing condition for sensing each data block, first setting data including a first sensing condition and second setting data including a second sensing condition, and wherein the control logic circuit is further configured to: perform a metadata open operation in response to an initialization command; store the first setting data and the second setting data in an initialization register; and sense the first memory plane under the first sensing condition and sense the second memory plane under the second sensing condition, in accordance with the first initialization information.

The objects of the disclosure are not limited to those mentioned above and additional objects of the disclosure, which are not mentioned herein, will be clearly understood by those skilled in the art from the following description of the disclosure.

### BRIEF DESCRIPTION OF DRAWINGS

The above and other aspects, features, and advantages of the disclosure will be more clearly understood from the following detailed description, taken in conjunction with the accompanying drawings.
FIG. 1 is a block diagram illustrating a storage device according to one or more example embodiments.
FIG. 2 is a block diagram illustrating a storage device according to one or more example embodiments.
FIG. 3 is a block diagram illustrating a nonvolatile memory device according to one or more example embodiments.
FIG. 4 is a view illustrating a memory block included in the memory cell array of FIG. 3.
FIG. 5 is a flow chart illustrating an operation of a memory controller according to one or more example embodiments.
FIG. 6 is a block diagram illustrating an operation of a memory controller according to one or more example embodiments.
FIG. 7 is a view illustrating a data block according to one or more example embodiments.
FIG. 8 is a view illustrating a method of classifying a plurality of data blocks into a first group and a second group by a memory controller according to one or more example embodiments.
FIG. 9 is a view illustrating a method of classifying a plurality of data blocks into a first group and a second group by a memory controller according to one or more example embodiments.
FIG. 10 is a view illustrating a method of classifying a plurality of data blocks into a first group and a second group by a memory controller according to one or more example embodiments.
FIG. 11 is a flow chart illustrating an operation of a memory controller according to one or more example embodiments.
FIG. 12 is a table illustrating a method of determining, by a memory controller, setting data required for sensing data blocks included in each group according to one or more example embodiments.
FIG. 13 is a table illustrating a method of determining, by a memory controller, setting data required for sensing data blocks included in each group according to one or more example embodiments.
FIG. 14 is a flow chart illustrating an operation of a nonvolatile memory device according to one or more example embodiments.
FIG. 15 is a block diagram illustrating a memory cell array according to one or more example embodiments.
FIG. 16 is a view illustrating setting data according to one or more example embodiments.
FIGS. 17 and 18 are views illustrating a method of sensing a memory block by a nonvolatile memory device according to one or more example embodiments.
FIG. 19 is a view illustrating setting data according to one or more example embodiments.
FIG. 20 is a view illustrating a method of sensing a memory block by a nonvolatile memory device according to one or more example embodiments.
FIG. 21 is a block diagram illustrating a host-storage system that includes a storage device according to one or more example embodiments.
FIG. 22 is a block diagram illustrating a system to which a storage device is applied according to one or more example embodiments.

### DETAILED DESCRIPTION

Hereinafter, one or more example embodiments according to the technical spirits of the disclosure will be described with reference to the accompanying drawings.

As used herein, an expression "at least one of" preceding a list of elements modifies the entire list of the elements and does not modify the individual elements of the list. For example, an expression, "at least one of a, b, and c" should be understood as including only a, only b, only c, both a and b, both a and c, both b and c, or all of a, b, and c.

In the disclosure, "write" may be used interchangeably with "program".

In a storage device, "sensing" may be a term that is generally used in various cases to refer determining whether a memory cell is an on-cell ('1') or an off-cell ('0') based on an amount of charges of a bit line of a memory cell array, or as a general term for an operation of writing, reading or erasing data in a memory cell. In the disclosure, "sensing" may be used as a general term for the operation of writing, reading and erasing data in a memory cell.

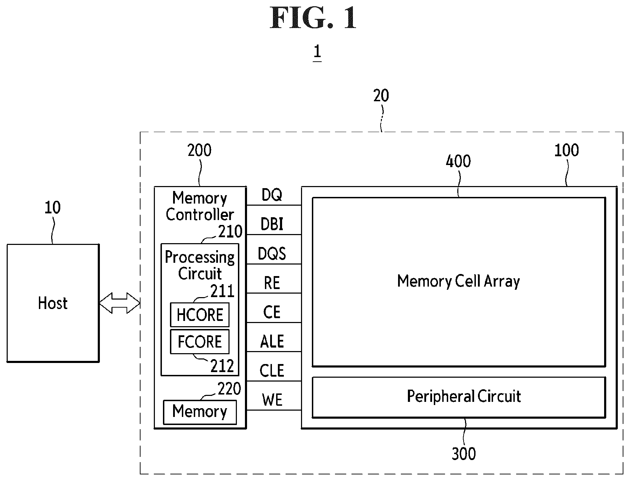

FIG. 1 is a block diagram illustrating a storage device according to one or more example embodiments.

Referring to FIG. 1, a storage system 1 may include a host 10 and a storage device 20. The storage system 1 may be implemented as, for example but not limited to, a personal computer (PC), a data server, a laptop computer, or a portable device. The portable device may be implemented as, for example but not limited to, a mobile phone, a smart phone, a tablet PC, a personal digital assistant (PDA), an enterprise digital assistant (EDA), a digital still camera, a digital video camera, a portable multimedia player (PMP), a personal navigation device (PND), a handheld game console, or an e-book. Furthermore, the storage system 1 may be implemented as a system-on-a-chip (SoC).

The host 10 may request the storage device 20 to perform a data processing operation, for example, a data read operation, a data write (program) operation, and/or a data erase operation. For example, the host 10 may include, for example but not limited to, a central processing unit (CPU), a graphic processing unit (GPU), a microprocessor, or an application processor (AP).

The storage device 20 may include a memory controller 200 and a nonvolatile memory device 100. The storage device 20 may be implemented as various types of storage devices such as, for example but not limited to, a solid-state drive (SSD), an embedded multimedia card (eMMC), a universal flash storage (UFS), a compact flash (CF), an secure digital (SD) card, a micro secure digital (Micro-SD) card, a mini secure digital (mini-SD) card, an extreme digital (xD) card, or a memory stick.

The memory controller 200 may be coupled to the host 10 and the storage device 20. In response to a request from the host 10, the memory controller 200 may be configured to access the nonvolatile memory device 100. For example, the memory controller 200 may be configured to control an overall operation of the storage device 20. The memory controller 200 may perform various management operations such as, for example but not limited to, cache/buffer management, firmware management, garbage collection management, wear leveling management, data deduplication removal management, read refresh/reclaim management, bad block management, multi-stream management, mapping management of host data and nonvolatile memory, quality of service (QoS) management, system resource allocation management, nonvolatile memory queue management, read level management, erase/program management, hot/cold data management, power loss protection management, dynamic thermal management and initialization management.

Although not clearly shown in the drawing, the memory controller 200 may be configured to provide an interface between the storage device 20 and the host 10. In addition, the memory controller 200 may be configured to drive firmware configured to control the storage device 20 in accordance with a request from the host 10 or by itself.

For example, the memory controller 200 may further include known components such as a host controller (HCORE) 211, a storage controller (FCORE) 212, a memory 220, a host interface (not shown), and a memory interface (not shown).

The host controller (HCORE) 211 may execute a host interface layer (HIL) of the firmware to transfer a read or write command of the host 10 to a flash translation layer (FTL) of the firmware.

The storage controller (FCORE) 212 may execute the FTL and a flash interface layer (FIL) of the firmware. The FIL may perform input/output of the nonvolatile memory device 100 and the memory controller 200. For example, data may be written in a mapped physical page address through the FTL, and/or data of the mapped physical page address may be read.

The host interface of the memory controller 200 may include a protocol for performing data exchange between the host 10 and the memory controller 200. For example, the memory controller 200 may be configured to communicate with the host 10 through at least one of various interface protocols such as, for example but not limited to, a Universal Serial Bus (USB) protocol, a Multimedia Card (MMC) protocol, a Peripheral Component Interconnection (PCI) protocol, a PCI-express (PCI-E) protocol, an Advanced Technology Attachment (ATA) protocol, a Serial-ATA protocol, a Parallel-ATA protocol, a Small Computer Small Interface (SCSI) protocol, an enhanced small disk interface (ESDI) protocol and an Integrated Drive Electronics (IDE) protocol.

The memory interface of the memory controller 200 may transmit and receive signals to and from the nonvolatile memory device 100 through a plurality of pins. For example, the plurality of pins may transmit DQ, DBI, DQS, RE, CE, ALE, CLE and WE signals, respectively.

The DQ signal may be a data signal, and may include a command CMD, an address ADDR and data DATA that are transferred. The DQ signal may be transferred through a plurality of data signal lines. The DBI signal may be a data bus inversion signal, and the memory controller 200 and the nonvolatile memory device 100 may transmit and receive data on which a data bus conversion computation or a data masking computation has been performed. For example, data may be encrypted for security or privacy. The DQS signal may be a data strobe signal, and the RE signal may be a read enable signal, and these signals may be input as data output control signals when reading data from a nonvolatile memory chip. The RE signal may be used to generate the DQS signal. The CE signal may be a chip enable signal, and may be a signal that the memory controller 200 selectively activates and accesses at least one of the nonvolatile memory devices 100. The CLE signal may be a command latch enable signal, and the ALE signal may be an address latch enable signal, wherein the CLE signal is enabled when the command CMD is included in the DQ signal, the ALE signal is enabled when the address ADDR is included in the DQ signal, and the CLE signal or the ALE signal is disabled when general data is transmitted to the DQ signal. The WE signal is a write enable signal, and the memory controller 200 may transmit the data signal DQ, which includes the command CMD or the address ADDR, and the switched write enable signal WE to the nonvolatile memory device 100.

For example, the nonvolatile memory device 100 may perform a write operation, a read operation, and /or an erase operation by latching the command CMD or the address ADD at an edge of the WE signal in accordance with the CLE signal and the ALE signal. For example, during the read operation, the CE signal may be activated, the CLE signal may be activated at a transmission period of the command, the ALE signal may be activated at a transmission period of the address, and the RE signal may be toggled at a period at which data is transmitted through a line of the data signal DQ. The DQS signal may be toggled at a frequency corresponding to a data input/output speed. The read data may be sequentially transmitted in synchronization with the data strobe signal DQS.

The nonvolatile memory device 100 may include a memory cell array 400 and a peripheral circuit unit 300 connected to the memory cell array 400, and the memory cell array 400 may include a plurality of memory planes. The nonvolatile memory device 100 may support a plane independent command (PIC). The PIC may mean that in the nonvolatile memory device 100 including a plurality of memory planes, even when one memory plane is in a busy state, read, program and erase operations for another memory plane may be performed. The memory 220 may be used as at least one of an operation memory of the host controller 211 or the storage controller 212, a cache memory between the storage device 20 and the host 10, and a buffer memory between the storage device 20 and the host 10. For example, the memory 220 may be implemented as a random access memory (RAM). The storage controller 212 may control an overall operation of the memory controller 200.

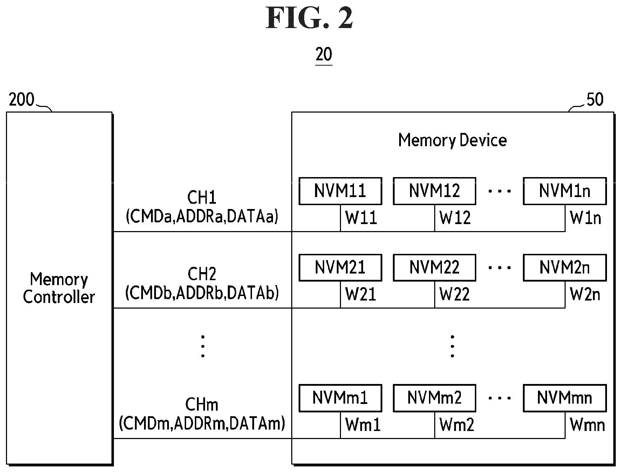

FIG. 2 is a block diagram illustrating a storage device according to one or more example embodiments.

Referring to FIG. 2, the storage device 20 may include a memory device 50 and a memory controller 200.

The storage device 20 may support a plurality of channels CH1 to CHm, and the memory device 50 and the memory controller 200 may be connected to each other through the plurality of channels CH1 to CHm.

The memory device 50 may include nonvolatile memory devices NVM11 to NVMmn. The nonvolatile memory device 100 of FIG. 1 may be any one of the nonvolatile memory devices NVM11 to NVMmn, but the disclosure is not limited thereto. Each of the nonvolatile memory devices NVM11 to NVMmn may be connected to one of the plurality of channels CH1 to CHm through a corresponding way (e.g., a corresponding one of ways W11 to W1n, ways W21 to W2n and ways Wm1 to Wmn). For example, the nonvolatile memory devices NVM11 to NVM1n may be connected to the first channel CH1 through ways W11 to W1n, and the nonvolatile memory devices NVM21 to NVM2n may be connected to the second channel CH2 through ways W21 to W2n. Each of the nonvolatile memory devices NVM11 to NVMmn may be implemented as a random memory unit that may operate in accordance with an individual command from the memory controller 200. For example, each of the nonvolatile memory devices NVM11 to NVMmn may be implemented as a memory chip or a memory die, but the disclosure is not limited thereto.

The memory controller 200 may transmit and receive signals to and from the memory device 50 through the plurality of channels CH1 to CHm. For example, the memory controller 200 may transmit commands CMDa to CMDm, addresses ADDRa to ADDRm, and data DATAa to DATAm to the memory device 50 respectively through the channels CH1 to CHm, or may receive data the DATAa to DATAm from the memory device 50 respectively through the channels CH1 to CHm.

The memory controller 200 may select one of the nonvolatile memory devices NVM11 to NVMmn connected to a corresponding channel through each channel, and may transmit and receive signals to and from the selected nonvolatile memory device. For example, the memory controller 200 may select the nonvolatile memory device NVM11 from the nonvolatile memory devices NVM11 to NVM1n connected to the first channel CH1. The memory controller 200 may transmit the command CMDa, the address ADDRa and the data DATAa to the selected nonvolatile memory device NVM11 through the first channel CH1, or may receive the data DATAa from the selected nonvolatile memory device NVM11 through the first channel CH1.

The memory controller 200 may transmit and receive signals to and from the memory device 50 in parallel through different channels. For example, while the command CMDa is transmitted to the memory device 50 through the first channel CH1, the memory controller 200 may transmit the command CMDb to the memory device 50 through the second channel CH2. For example, while the memory controller 200 receives the data DATAa from the memory device 50 through the first channel CH1, the memory controller 200 may receive the data DATAb from the memory device 50 through the second channel CH2.

The memory controller 200 may control the overall operation of the memory device 50. The memory controller 200 may control each of the nonvolatile memory devices NVM11 to NVMmn connected to the channels CH1 to CHm by transmitting signals to the channels CH1 to CHm. For example, the memory controller 200 may control one selected from the nonvolatile memory devices NVM11 to NVM1n by transmitting the command CMDa and the address ADDRa to the first channel CH1.

Each of the nonvolatile memory devices NVM11 to NVMmn may operate in accordance with the control of the memory controller 200. For example, the nonvolatile memory device NVM11 may program the data DATAa in accordance with the command CMDa and the address ADDRa, which are provided to the first channel CH1. For example, the nonvolatile memory device NVM21 may read the data DATAb in accordance with the command CMDb and the address ADDRb, which are provided to the second channel CH2, and may transmit the read data DATAb to the memory controller 200.

Although FIG. 2 shows that the memory device 50 communicates with the memory controller 200 through 'm' number of channels CH1 to CHm and the memory device 50 includes 'n' number of nonvolatile memory devices corresponding to each channel, various modifications may be made in the number of channels and the number of nonvolatile memory devices connected to one channel.

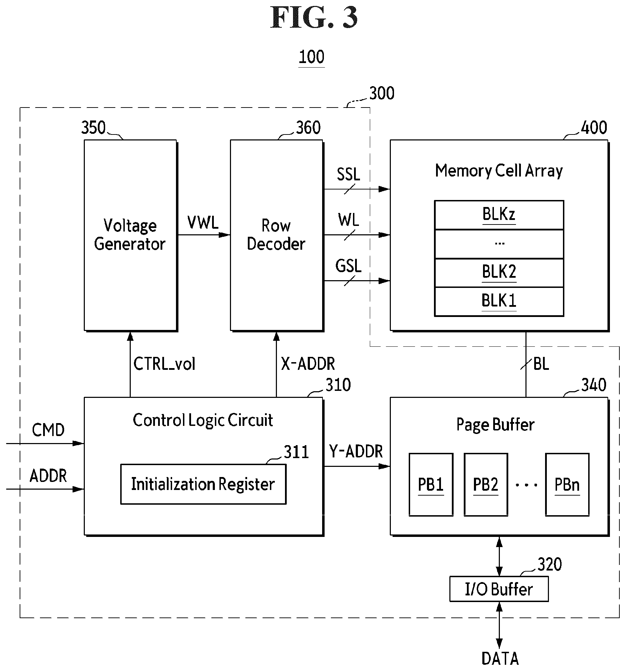

FIG. 3 is a block diagram illustrating a nonvolatile memory device according to one or more example embodiments.

Referring to FIG. 3, the nonvolatile memory device 100 may include a memory cell array 400 and a peripheral circuit unit 300 connected to the memory cell array 400. The nonvolatile memory device 100 may correspond to one of the nonvolatile memory devices NVM11 to NVMmn described with reference to FIG. 2. The peripheral circuit unit 300 may include a voltage generator 350, a row decoder 360, a page buffer 340, an input/output (I/O) buffer 320, and a control logic circuit 310. The memory cell array 400 may include a plurality of memory blocks BLK1 to BLKz. Each of the plurality of memory blocks BLK1 to BLKz may be connected to the row decoder 360 through a word line WL, a string selection line SSL, and a ground selection line GSL, and may be connected to the page buffer 340 through a bit line BL.

The memory cell array 400 may include a plurality of memory cells disposed in regions where a plurality of word lines WLs and a plurality of bit lines BL cross each other. Each of the memory cells may be formed in various cell types including, for example but not limited to, a single level cell (SLC), a multi level cell (MLC), a triple level cell (TLC), a quad level cell (QLC), and the like.

The control logic circuit 310 may receive the command CMD and the address ADDR to generate a control signal CTRL_vol for controlling the voltage generator 350 and a control signal for controlling the page buffer 340, and may generate a row address X_ADDR and a column address Y_ADDR based on the address ADDR. The control logic circuit 310 may output the row address X_ADDR to the row decoder 360 and output the column address Y_ADDR to the input/output buffer 320.

The voltage generator 350 may receive power PWR, regulate a word line basic voltage VWL for a memory operation in accordance with the control signal CTRL_vol from the control logic circuit 310 and provide the word line basic voltage VWL to the memory cell array 400 through the row decoder 360.

The row decoder 360 may be connected to the memory cell array 400 through the word line WL, the string selection line SSL, and the ground selection line GSL. The row decoder 360 may decode the row address X_ADDR input from the control logic circuit 310 to select at least one of the plurality of memory blocks BLK1 to BLKz. That is, the row decoder 360 may select the word line WL, the string selection line SSL, and the ground selection line GSL by using the row address X_ADDR. The row decoder 360 may provide the word line basic voltage VWL supplied from the voltage generator 350 to the word line WL.

The page buffer 340 may be connected to the memory cell array 400 through the bit line BL, and may be connected to the input/output buffer 320 through the bit line BL. During the program operation, the input/output buffer 320 may receive program data DATA provided from the memory controller (e.g., 200 of FIG. 1) and may provide the program data DATA to the page buffer 340 based on the column address Y_ADDR provided from the control logic circuit 310. During the read operation, the input/output buffer 320 may provide the read data DATA stored in the page buffer 340 to the memory controller (e.g., 200 of FIG. 1) based on the column address Y_ADDR provided from the control logic circuit 310.

The control logic circuit 310 may control the overall operation of the nonvolatile memory device 100 and output each control signal related to the memory operation. For example, the control logic circuit 310 may control the nonvolatile memory device 100 by using an internal control signal based on at least one of the address ADDR, the command CMD and the control signal CTRL, which is received from the memory controller 200.

The control logic circuit 310 may include an initialization register 311 that includes a latch. The latch may be an E-Fuse type latch. The control logic circuit 310 may read setting data, store the read setting data in the initialization register 311 and generate an internal control signal based on at least one of the address ADDR, the command CMD and the control signal CTRL and the stored setting data. The setting data will be described in more detail later.

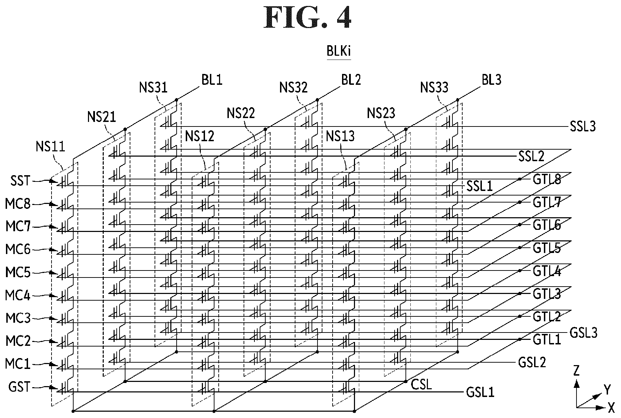

FIG. 4 is a view illustrating a memory block included in the memory cell array of FIG. 3.

Referring to FIG. 4, each of the plurality of memory blocks BLK1 to BLKz may be formed on a substrate in a three-dimensional structure. For example, an (i)th memory block BLKi may include a plurality of memory NAND strings NS11 to NS33 connected between a plurality of bit lines BL1 to BL3 and a common source line CSL. Each of the plurality of memory NAND strings NS11 to NS33 may include a string selection transistor SST, a plurality of memory cells MCs, and a ground selection transistor GST. Although FIG. 3 shows that there are three bit lines BL1 to BL3 and nine memory NAND strings NS11 to NS33 and each of the plurality of memory NAND strings NS11 to NS33 includes eight memory cells MCs, but the disclosure is not limited thereto, and may be implemented in different numbers in accordance with embodiments.

A gate of the string selection transistor SST may be connected to a corresponding string selection line among string selection lines SSL1 to SSL3. The plurality of memory cells MCs may be connected to corresponding word lines WL1 to WL8, respectively. The word lines WL1 to WL8 may correspond to gate lines GTL1 to GTL 8. A gate of the ground selection transistor GST may be connected to a corresponding ground selection line among ground selection lines GSL1 to GSL3. The string selection transistor SST may be connected to a corresponding bit line among the plurality of bit lines BL1 to BL3, and the ground selection transistor GST may be connected to the common source line CSL.

Word lines (e.g., WL1) of the same height in the (i)th memory block BLKi may be connected in common, and the ground selection lines GSL1 to GSL3 and the string selection lines SSL1 to SSL3 of the same height in the (i)th memory block BLKi may be separately provided, respectively.

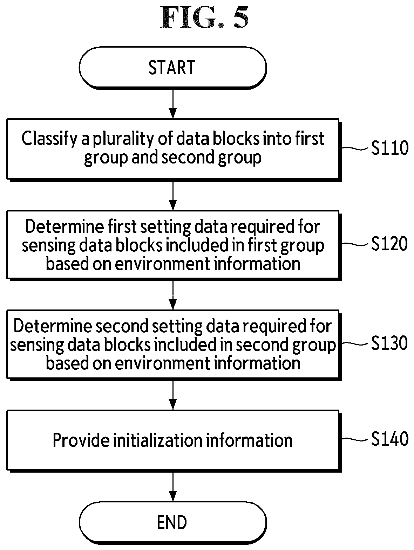

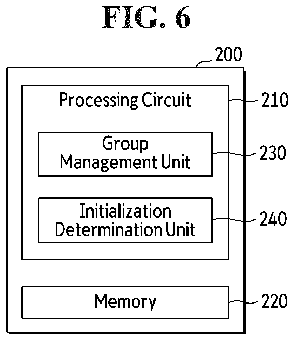

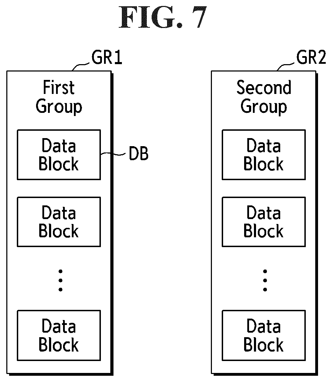

FIG. 5 is a flow chart illustrating an operation of a memory controller according to one or more example embodiments. FIG. 6 is a block diagram illustrating an operation of a memory controller according to one or more example embodiments. FIG. 7 is a view illustrating a data block according to one or more example embodiments.

The operation of the memory controller will be described with reference to FIGS. 5 to 7.

The memory controller 200 may include a processing circuit 210 and a memory 220 as described above. The memory 220 may include firmware, which may be a set of a plurality of command languages for designating an operation of the processing circuit 210. The processing circuit 210 may control the operation of the memory device (e.g., 50 of FIG. 2) by executing the firmware stored in the memory 220. The processing circuit 210 may execute the firmware stored in the memory 220 to implement a group management unit 230 and an initialization determination unit 240, but the disclosure is not limited thereto. The group management unit 230 and the initialization determination unit 240 may be configured as hardware including separate circuits, and may be present in the memory controller 200 or may be integrally formed with the processing circuit 210. The memory device may include (store) a plurality of data blocks DB. The data block DB may correspond to a group of data or a zone in which a storage space in the memory device is logically or physically divided.

For example, a concept of zone namespace (ZNS) has been introduced, which allows a plurality of users or a plurality of applications to use a storage without interference with each other. Since a concept of zone namespace is known, its detailed description will be omitted. In this case, the data block DB may correspond to a plurality of zones allocated to each user or each application.

For another example, in order to efficiently manage a storage space of the storage, a concept of flexible data placement (FDP) was introduced, and in this case, the data block DB may correspond to a reclaim unit (RU) that is a unit of space in which data may be arranged. Since FDP is known to those skilled in the art, its detailed description will be omitted. As another example, the data block DB may correspond to a physical function (PF) in a concept of single root I/O virtualization (SR-IOV), which is one of the known virtualization technologies. However, the data block DB is not limited to the above concepts.

The memory controller 200 may classify a plurality of data blocks into a first group and a second group (S110). For example, the group management unit 230 of the memory controller 200 may classify a plurality of data blocks DB into a first group GR1 and a second group GR2. Various criteria for classifying the plurality of data blocks DB into the first group GR1 and the second group GR2 by the group management unit 230 will be described later. In the disclosure, it is described that the group management unit 230 classifies a plurality of data blocks DB into two groups, but the embodiment is not limited thereto, and the data block DB may be classified into three or more groups.

The memory controller 200 may determine first setting data required for sensing data blocks included in the first group, based on environment information (S120). For example, the initialization determination unit 240 of the memory controller 200 may determine first setting data required for sensing the plurality of data blocks DB included in the first group GR1, based on the environment information. Details of the environment information will be described later.

The memory controller 200 may determine second setting data required for sensing data blocks included in the second group, based on the environment information (S130). For example, the initialization determination unit 240 of the memory controller 200 may determine second setting data required for sensing the plurality of data blocks DB included in the second group GR2, based on the environment information. Details of the environment information will be described later.

The memory controller 200 may provide initialization information (S140). For example, the processing circuit 210 of the memory controller 200 may provide initialization information generated by the operation of the initialization determination unit 240 to the memory device (e.g., 100 of FIG. 1). The initialization information may include information on the determined setting data. The initialization information may be stored in a specific region of the memory device.

According to some embodiments, the memory controller 200 may classify a plurality of data blocks into several groups in accordance with various criteria, determine setting data required for setting a sensing condition appropriate for each group in accordance with environment information reflecting characteristics of the data blocks and provide the same to the memory device. The memory device may write or read data by applying setting data appropriate for each group based on the provided information. For example, the memory device may load first setting data for sensing memory blocks belonging to the first group in accordance with the initialization information provided from the memory controller. The memory device may sense memory blocks belonging to the first group under a first sensing condition in accordance with the first setting data. Also, the memory device may load second setting data for sensing memory blocks belonging to the second group in accordance with the initialization information provided from the memory controller. The memory device may sense memory blocks belonging to the second group under a second sensing condition in accordance with the second setting data. In other words, it is possible to provide a memory controller, which is used by adaptively applying various setting data in accordance with characteristics of data blocks belonging to each group, and a storage device and a nonvolatile memory device, which are used by adaptively applying various setting data in accordance with characteristics of data blocks belonging to each group.

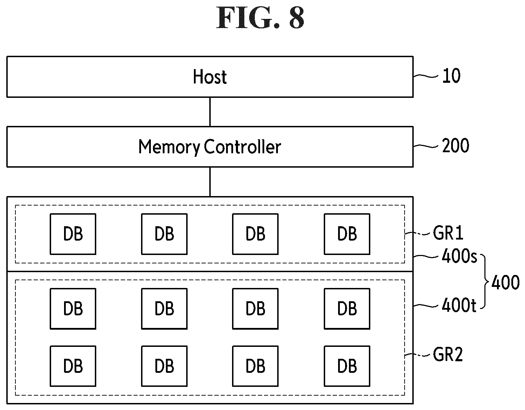

FIG. 8 is a view illustrating a method of classifying a plurality of data blocks into a first group and a second group by a memory controller according to one or more example embodiments.

Referring to FIG. 8, the memory controller 200 may classify a plurality of data blocks DB into a first group and a second group by itself or under the control of the host (e.g., 10 of FIG. 1). As described above, the memory cell array 400 of the memory device may include a plurality of memory cells. Each memory cell may be formed in various cell types including a single level cell (SLC), a multi-level cell (MLC), a triple level cell (TLC), a Quad level cell (QLC), and the like. The memory cell array 400 may include, for example, a first level space 400s and a second level space 400t. The first level space 400s may include one or more first level memory cells. The first level memory cell may be any one of, for example, SLC, MLC and TLC. The second level space 400t may include one or more second level memory cells. The second level memory cell may be a memory cell that stores data of a larger number of bits per cell than the first level memory cell. That is, when the first level memory cell is, for example, SLC, the second level memory cell may correspond to one or more of MLC, TLC and QLC. When the first level memory cell is, for example, MLC, the second level memory cell may correspond to one or more of TLC and QLC. When the first level memory cell is, for example, TLC, the second level memory cell may correspond to QLC.

The memory controller 200 may classify a plurality of data blocks DB belonging to the first level space 400s into a first group GR1, and may classify a plurality of data blocks DB belonging to the second level space 400t into a second group GR2. In other words, the memory controller 200 may classify data blocks included (stored) in the first level memory cells among the plurality of data blocks into the first group GR1, and may classify data blocks included (stored) in the second level memory cells among the plurality of data blocks into the second group GR2.

The memory controller 200 may determine first setting data required for sensing the data blocks included in the first group GR1, based on the environment information, and may determine second setting data required for sensing data blocks included in the second group GR2. The memory controller 200 may provide initialization information including information on the determined setting data to the memory device.

The memory device may load the first setting data for sensing memory blocks belonging to the first group GR1 in accordance with the initialization information. Also, the memory device may load the second setting data for sensing memory blocks belonging to the second group GR2 in accordance with the initialization information provided from the memory controller.

The memory device may sense the memory blocks belonging to the first group GR1 under the first sensing condition in accordance with the first setting data. The memory device may sense the memory blocks belonging to the second group GR2 under the second sensing condition in accordance with the second setting data. In other words, the memory device may sense a plurality of data blocks DB included in the first level memory cells under the first sensing condition in accordance with the first setting data, and may sense a plurality of data blocks DB included in the second level memory cells under the second sensing condition in accordance with the second setting data.

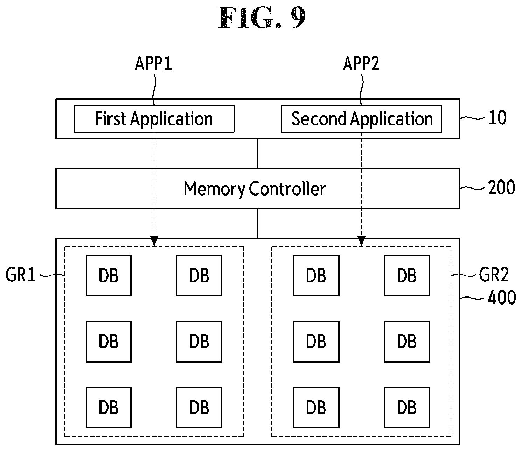

FIG. 9 is a view illustrating a method of classifying a plurality of data blocks into a first group and a second group by a memory controller according to one or more example embodiments.

Referring to FIG. 9, the memory controller 200 may classify a plurality of data blocks DB into a first group GR1 and a second group GR2 by itself or under the control of the host 10. In this case, a portion of the data blocks DB may be data blocks DB allocated to a first application APP1 (or first user) of the host 10. Another portion of the data blocks DB may be data blocks DB allocated to a second application APP2 (or second user) of the host 10. The memory controller 200 may classify, among a plurality of data blocks DB, data blocks DB, in which data of the first application APP1 (or first user) is written and read, as the first group GR1, and may classify data blocks DB, in which data of the second application APP2 (or second user) is written and read, as the second group GR2.

The memory controller 200 may determine first setting data required for sensing data blocks included in the first group GR1, based on the environment information, and may determine second setting data required for sensing data blocks included in the second group GR2. The memory controller 200 may provide initialization information including information on the determined setting data to the memory device.

The memory device may load the first setting data for sensing the memory blocks belonging to the first group GR1 in accordance with the initialization information. Also, the memory device may load the second setting data for sensing the memory blocks belonging to the second group GR2 in accordance with the initialization information provided from the memory controller.

The memory device may sense the memory blocks belonging to the first group GR1 under the first sensing condition in accordance with the first setting data. The memory device may sense the memory blocks belonging to the second group GR2 under the second sensing condition in accordance with the second setting data. In other words, the memory device may sense the plurality of data blocks DB allocated to the first application under the first sensing condition in accordance with the first setting data, and may sense the plurality of data blocks DB allocated to the second application different from the first application under the second sensing condition in accordance with the second setting data.

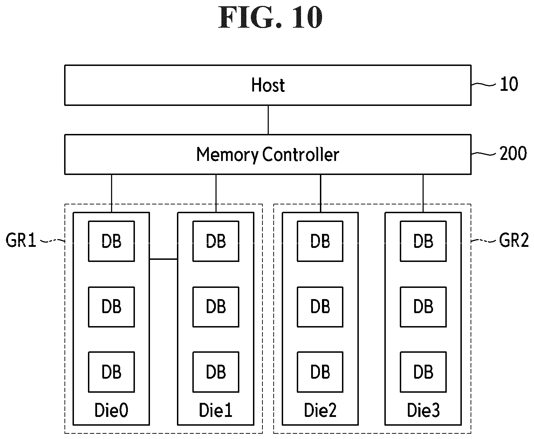

FIG. 10 is a view illustrating a method of classifying a plurality of data blocks into a first group and a second group by a memory controller according to one or more example embodiments.

Referring to FIG. 10, the memory controller 200 may classify a plurality of data blocks DB into a first group GR1 and a second group GR2 by itself or under the control of the host 10. The memory device (e.g., 50 of FIG. 2) may include a plurality of nonvolatile memory devices NVM11 to NVMmn as described above. Each of the plurality of nonvolatile memory devices NVM11 to NVMmn may be implemented as a random memory unit, for example, a memory chip or a memory die, which may operate in accordance with an individual command from the memory controller 200. The memory controller 200 may include, for example, first to fourth memory dies Die0, Die1, Die2 and Die3, which may operate in accordance with an individual command. Although four memory dies are shown in FIG. 10, but the disclosure is not limited thereto, there may be fewer or more memory dies in the memory device, which may operate in accordance with an individual command. The memory controller 200 may classify memory dies into groups. For example, the first and second memory dies Die0 and Die1 may be classified into the first group GR1, and the third and fourth memory dies Die2 and Die3 may be classified into the second group GR2. That is, the data blocks DB included in the first and second memory dies Die0 and Die1 may be classified into the first group GR1, and the data blocks DB included in the third and fourth memory dies Die2 and Die3 may be classified into the second group GR2. The classification method is not limited to the above examples, and in an embodiment, each memory die may be classified into one of different groups. For example, the first memory die0 may be classified into the first group GR1, and the second memory die Die1 may be classified into the second group GR2.

The memory controller 200 may determine first setting data required for sensing the data blocks included in the first group GR1, based on the environment information, and may determine second setting data required for sensing the data blocks included in the second group GR2. The memory controller 200 may provide initialization information including information on the determined setting data to the memory device.

The memory device may load the first setting data for sensing memory blocks belonging to the first group GR1 in accordance with the initialization information. Also, the memory device may load the second setting data for sensing memory blocks belonging to the second group GR2 in accordance with the initialization information provided from the memory controller.

The memory device may sense the memory blocks belonging to the first group GR1 under the first sensing condition in accordance with the first setting data. The memory device may sense the memory blocks belonging to the second group GR2 under the second sensing condition in accordance with the second setting data. In other words, the memory device may sense a plurality of data blocks DB included in the first memory dies (e.g., Die0 and Die1 of FIG. 10) under the first sensing condition in accordance with the first setting data, and may sense a plurality of data blocks DB included in the second memory dies (e.g., Die2 and Die3 of FIG. 10) under the second sensing condition in accordance with the second setting data.

Although the method of classifying a plurality of data blocks into a first group and a second group by the memory controller has been described in detail in FIGS. 8 to 10, the method of classifying a plurality of data blocks into a first group and a second group by the memory controller is not limited to the method described in FIGS. 8 to 10, and the plurality of data blocks may be classified into the first group and the second group in various methods, and the plurality of data blocks may be classified into three or more groups instead of two groups.

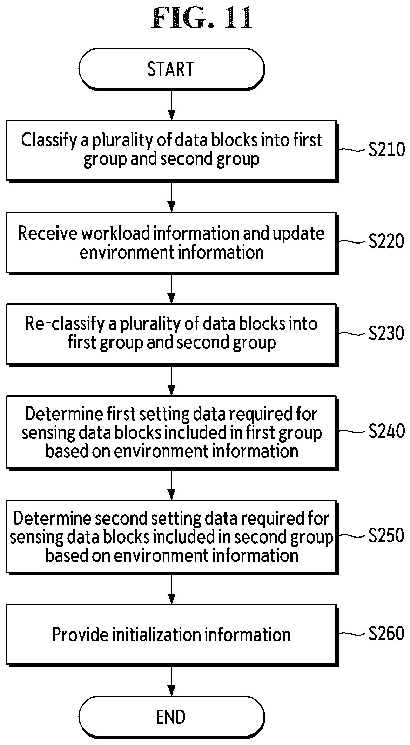

FIG. 11 is a flow chart illustrating an operation of a memory controller according to one or more example embodiments.

In addition to those described with reference to FIGS. 5 to 7, the operation of the memory controller will be described with reference to FIG. 11.

The memory controller may classify a plurality of data blocks into a first group and a second group (S210). Since S210 corresponds to S110 of FIG. 5 and has been described in detail above, its detailed description will be omitted.

The memory controller may receive workload information and update environment information (S220). For example, the processing circuit 210 of the memory controller 200 may receive workload information from the memory device. The workload information may be information used for the memory controller 200 to classify a plurality of data blocks into a first group and a second group and to determine setting data required for sensing data blocks included in the first group and the second group. The processing circuit 210 of the memory controller 200 may update environment information based on the received workload information.

The memory controller may re-classify the plurality of data blocks into the first group and the second group based on the workload information (S230). For example, the group management unit 230 of the memory controller 200 may re-classify the plurality of data blocks into the first group and the second group based on the workload information received from the memory device.

The memory controller may determine first setting data required for sensing the data blocks included in the first group based on the environment information (S240). For example, the initialization determination unit 240 of the memory controller 200 may update the environment information based on the workload information received from the memory device, and may determine first setting data required for sensing the data blocks included in the first group based on the updated environment information.

The memory controller may determine second setting data required for sensing the data blocks included in the second group based on the environment information (S250). For example, the initialization determination unit 240 of the memory controller 200 may update the environment information based on the workload information received from the memory device, and may determine second setting data required for sensing the data blocks included in the second group based on the updated environment information.

The memory controller may provide initialization information (S260). Since S260 corresponds to S140 of FIG. 5 and has been described in detail above, its detailed description will be omitted.

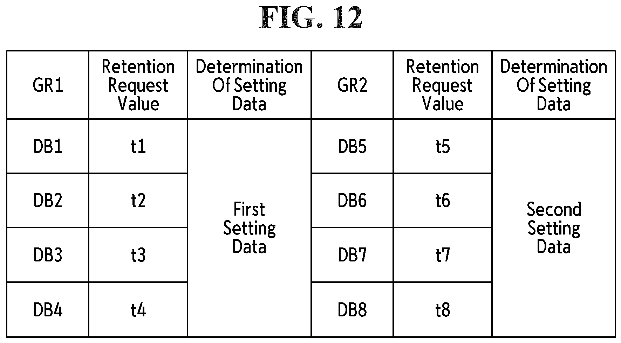

FIG. 12 is a table illustrating a method of determining, by a memory controller, setting data required for sensing data blocks included in each group according to one or more example embodiments.

The method of determining setting data required for sensing data blocks included in each group by the memory controller will be described in detail with reference to FIGS. 6 and 12.

The environment information may include a first retention parameter of data blocks included in the first group GR1 and a second retention parameter of data blocks included in the second group GR2. It is assumed that among the plurality of data blocks DB of the memory device, the first to fourth data blocks DB1 to DB4 belong to the first group GR1 and the fifth to eighth data blocks DB5 to DB8 belong to the second group GR2. The initialization determination unit 240 of the memory controller 200 may determine first setting data required for sensing the data blocks DB1 to DB4 included in the first group GR1, based on the first retention parameter of the first to fourth data blocks DB1 to DB4 included in the first group GR1. The first retention parameter may include, for example, information on a retention request value for each of the data blocks DB1 to DB4 included in the first group GR1.

Unintended deformation of data may occur in the memory device due to various factors such as degradation of memory cells, which is caused by long use. For example, when a nonvolatile memory device such as a NAND flash memory is left unattended for a long time after data is programmed, deformation may occur in distribution of a threshold voltage due to outflow of charges or movement of a hole. The number of bits at which an error occurs when data is read may be increased in accordance with the deformation in distribution of the threshold voltage.

Accordingly, there may be a need for users of the storage device to ensure that the data stored in the memory device is maintained in an original state for a certain period of time. For example, there may be a need for the users of the storage device to ensure that the data stored in the memory device is maintained in the original state for at least one week. The data retention period according to the request of the users of the storage device may be referred to as a retention request value. Various retention request values, for example, one week, two weeks, three weeks, one month, and three months may exist.

The initialization determination unit 240 of the memory controller 200 may determine setting data required for sensing the data blocks DB1 to DB4 included in the first group as first setting data based on the first retention parameter, for example, information on each of retention request values t1, t2, t3 and t4 of the first to fourth data blocks DB1 to DB4 included in the first group. Likewise, the initialization determination unit 240 of the memory controller 200 may determine second setting data required for sensing the data blocks DB5 to DB8 included in the second group GR2 based on the second retention parameter, for example, information on each of retention request values t5, t6, t7 and t8 of the fifth to eighth data blocks DB5 to DB8 included in the second group GR2, but the embodiment is not limited thereto. The retention parameter may include more various information in addition to the retention request value for each data block DB, and may determine the setting data (e.g., the first setting data and the second setting data) based on such information.

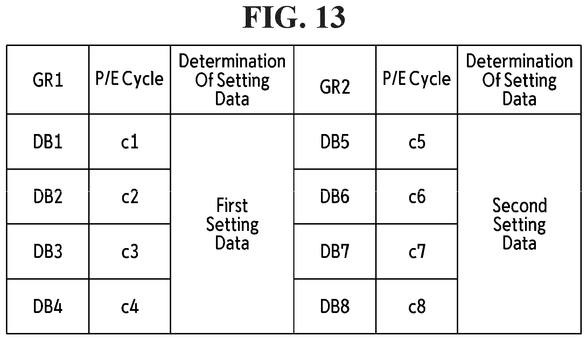

FIG. 13 is a table illustrating a method of determining, by a memory controller, setting data required for sensing data blocks included in each group according to one or more example embodiments.

The method of determining setting data required for sensing data blocks included in each group by the memory controller will be described in detail with reference to FIGS. 6 and 13.

It is assumed that among the plurality of data blocks DB of the nonvolatile memory device, for example, the first to fourth data blocks DB1 to DB4 belong to the first group GR1 and the fifth to eighth data blocks DB5 to DB8 belong to the second group GR2. According to some embodiments, the environment information may include a first durability parameter of the data blocks included in the first group GR1 and a second durability parameter of the data blocks included in the second group GR2. The initialization determination unit 240 of the memory controller 200 may determine first setting data required for sensing the data blocks DB1 to DB4 included in the first group GR1 based on a first durability parameter of the first to fourth data blocks DB1 to DB4 included in the first group GR1. The first durability parameter may include, for example, information on a program/ease (P/E) cycle or an erase count for each of the data blocks DB included in the first group GR1. In FIG. 13, it is described that the setting data is determined based on the information on the program/ease cycle, but the embodiment is not limited thereto.

The initialization determination unit 240 of the memory controller 200 may determine the setting data required for sensing the data blocks DB1 to DB4 included in the first group GR1 as the first setting data based on the first durability parameter, for example, information on each of P/E cycles c1, c2, c3 and c4 of the first to fourth data blocks DB1 to DB4 included in the first group. Likewise, the initialization determination unit 240 of the memory controller 200 may determine the second setting data required for sensing the data blocks DB5 to DB8 included in the second group GR2 based on the second durability parameter, for example, information on each of the P/E cycle c5, c6, c7 and c8 of the fifth to eighth data blocks DB5 to DB8 included in the second group GR2, but the embodiment is not limited thereto. The durability parameter may include more various information in addition to the P/E cycle or the erase count for each data block DB, and may determine the setting data (e.g., the first setting data and the second setting data) based on such information.

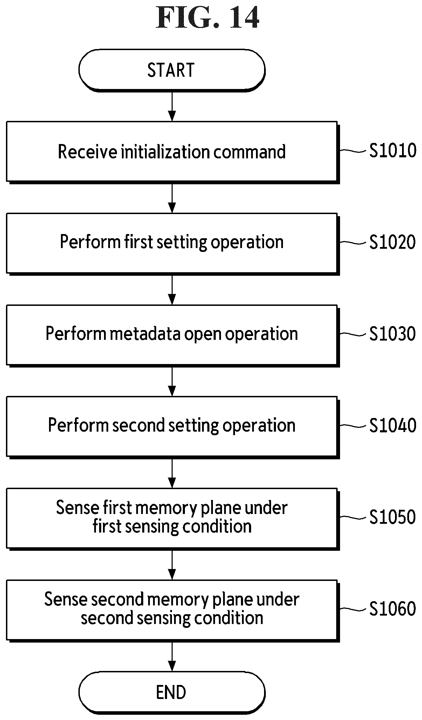

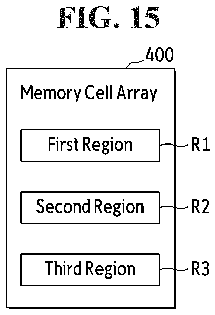

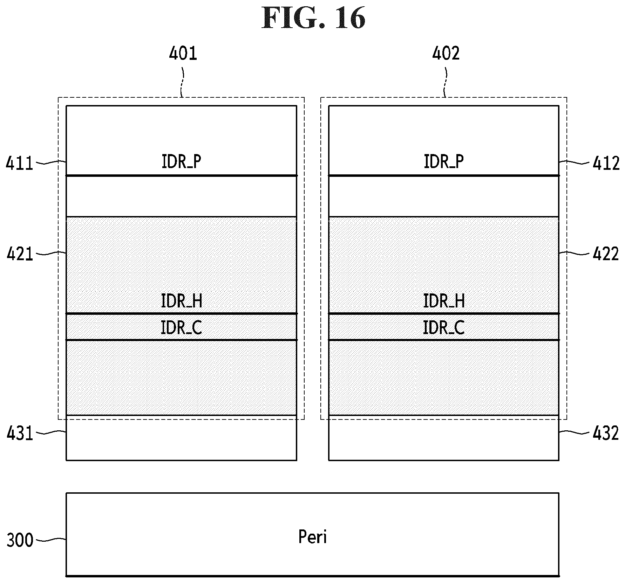

FIG. 14 is a flow chart illustrating an operation of a nonvolatile memory device according to one or more example embodiments. FIG. 15 is a block diagram illustrating a memory cell array according to one or more example embodiments. FIG. 16 is a view illustrating setting data according to one or more example embodiments. The operation of the nonvolatile memory device will be described with reference to FIGS. 14 to 16.

First, referring to FIG. 15, a memory cell array 400 of the nonvolatile memory device may include a first region R1, a second region R2, and a third region R3. Division of the first region R1, the second region R2 and the third region R3 may be a variable and logical division not a physical division. The first region R1 and the second region R2 may be collectively referred to as a meta region. Metadata may be stored in the meta region. The third region R3 may be expressed as a user region. User data may be stored in the third region R3. The memory controller may designate at least a portion of a plurality of memory blocks (e.g., BLK1 to BLKz of FIG. 3) included in the memory cell array 400 as the first region R1, designate another portion as the second region R2 and designate a remaining portion as the third region R3.

Referring to FIG. 16, the memory cell array 400 of the nonvolatile memory device may include a memory plane 401 and a replica memory plane 402.

The setting data may be also referred to as information data read (IDR) data. The setting data refers to data required for the operation of the nonvolatile memory device, and more particularly, may include option information, column repair information and bad block information for each memory die. The setting data may include setting conditions for operating the peripheral circuit unit 300, a pump circuit, etc. of the nonvolatile memory device. The setting data may be stored in a specific region (e.g., a specific word line WL) of the memory cell array 400 at a test stage of the nonvolatile memory device. In preparation for distortion caused by degradation of the memory cell array 400, the nonvolatile memory device may further store replica setting data used in place of the setting data. The replica setting data may be stored in a memory plane different from the memory plane 401 in which the setting data is stored, or may be stored in the same memory plane as the memory plane 401 in which the setting data is stored. There may be a plurality of replica setting data corresponding to one setting data.

Referring to FIG. 16, in the memory plane 401 of the nonvolatile memory device, preceding setting data IDR_P may be stored in one region 411 belonging to the first region R1. In the memory plane 401 of the nonvolatile memory device, two following setting data IDR_H and IDR_C may be stored in another region 421 belonging to the second region R2. The preceding setting data IDR_P may be setting data that are set precedent to setting of the following setting data and will be described in detail later. Although two following setting data IDR_H and IDR_C are shown in FIG. 16, the embodiment is not limited thereto, and three or more following setting data may be stored therein. In the memory plane 401 of the nonvolatile memory device, user data may be stored in another region 431 belonging to the third region R3. In the replica memory plane 402 of the nonvolatile memory device, replica setting data of the preceding setting data IDR_P may be stored in one region 412 belonging to the first region R1. In the replica memory plane 402 of the nonvolatile memory device, replica setting data of two following setting data IDR_H and IDR_C may be stored in another region 422 belonging to the second region R2. In the replica memory plane 402 of the nonvolatile memory device, user data may be stored in another region 432 belonging to the third region R3.

Referring to FIG. 14, the nonvolatile memory device may receive an initialization command (S1010). When the storage device is powered on, the memory controller may provide an initialization command to the nonvolatile memory device. The nonvolatile memory device may start the initialization operation in response to the initialization command.

The nonvolatile memory device may perform a first setting operation (S1020). The first setting operation may be performed for an operation preferentially required for the nonvolatile memory device. The first setting operation may include an operation of sensing the preceding setting data IDR_P, verifying validity of the sensed preceding setting data IDR_P, and storing the preceding setting data IDR_P of which validity has been verified in a specific space (e.g., initialization register). The preceding setting data IDR_P may be setting data including only setting data, which is preferentially required, among all setting data. The nonvolatile memory device may reduce the booting time of the storage device by performing the first setting operation by first using only the preceding setting data IDR_P that is preferentially required.

The nonvolatile memory device may perform a metadata open operation (S1030). The metadata open operation may indicate an operation of loading metadata recorded before power-off of the storage device and reconfiguring the loaded metadata into latest information. The memory controller may process various requests from the host by using the metadata. The metadata may be setting information on each element in the nonvolatile memory device. The metadata may include initialization information. The initialization information may be information for grouping a plurality of memory blocks in the storage device and determining setting data including a sensing condition appropriate for each group. Since the initialization information has been described above in detail together with the memory controller, its detailed description will be omitted herein.

The nonvolatile memory device may perform a second setting operation (S1040). The second setting operation may be performed for a general operation of the nonvolatile memory device. The second setting operation may include an operation of sensing the following setting data IDR_H and IDR_C, verifying validity of the sensed following setting data IDR_H and IDR_C, and storing the following setting data IDR_H and IDR_C of which validity has been verified in a specific space (e.g., initialization register). In this case, the nonvolatile memory device may store at least one of the two following setting data IDR_H and IDR_C in the specific space (e.g., initialization register) based on the initialization information.

When the second setting operation is performed, first setting data and second setting data may be stored in a specific space (e.g., initialization register) of the nonvolatile memory device. When setting an operation variable for operating the nonvolatile memory device, the nonvolatile memory device may use only one setting data, or may use two or more setting data together. The first setting data may be any one of the two following setting data IDR_H and IDR_C. The second setting data may be any one of the two following setting data IDR_H and IDR_C. The first setting data may include a first sensing condition. The first sensing condition may include various operation variables used in the nonvolatile memory device. For example, the first sensing condition may include at least one of a program time tPROG, a read time tR, and an erase time tERS when writing data in the nonvolatile memory device. For example, as the program time tPROG is increased, retention characteristics of data may be improved, but sequential write performance and random write performance may be reduced. The second setting data may include a second sensing condition. The second sensing condition may include various operation variables used in the nonvolatile memory device. In this case, the operation variables of the second sensing condition may have values different from the operation variables of the first sensing condition.

The nonvolatile memory device may sense a first data block under the first sensing condition (S1050), and the nonvolatile memory device may sense a second data block under the second sensing condition (S1060). S1050 and S1060 will be described in more detail later.

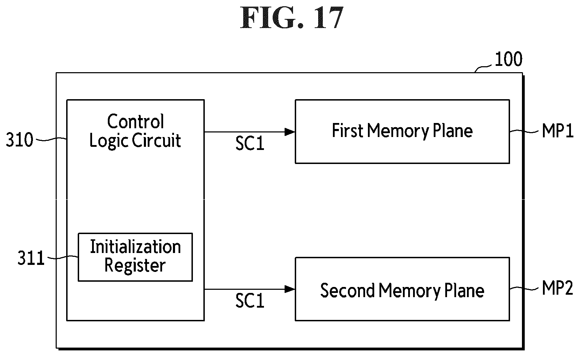

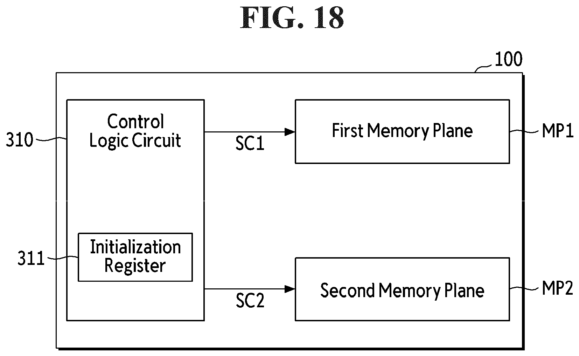

FIGS. 17 and 18 are views illustrating a method of sensing a memory block by a nonvolatile memory device according to one or more example embodiments.

Referring to FIGS. 17 and 18, the nonvolatile memory device 100 may sense a memory plane by applying the same or different setting data to different memory planes. For example, based on initialization information and setting data stored in the initialization register 311, the control logic circuit 310 of the nonvolatile memory device 100 may sense a first memory plane MP1 and a second memory plane MP2 under a first sensing condition SC1, or may sense the first memory plane MP1 under the first sensing condition SC1 and sense the second memory plane MP2 under the second sensing condition SC2.

According to the initialization information of the nonvolatile memory device 100, the first memory plane MP1 and the second memory plane MP2 may belong to the same group, or the first memory plane MP1 and the second memory plane MP2 may belong to different groups. For example, the first memory plane MP1 may include (store) a first data block, and the second memory plane MP2 may include (store) a second data block. When the first data block and the second data block belong to the same group, the first memory plane MP1 and the second memory plane MP2 may belong to the same group, and when the first data block and the second data block belong to different groups, the first memory plane MP1 and the second memory plane MP2 may belong to different groups.

When the first data block and the second data block belong to the first group, the control logic circuit 310 of the nonvolatile memory device 100 may sense the first memory plane MP1 and the second memory plane MP2 under the first sensing condition SC1 by using the first setting data stored in the initialization register 311. When the first data block belongs to the first group and the second data block belongs to the second group, the control logic circuit 310 of the nonvolatile memory device 100 may sense the first memory plane MP1 under the first sensing condition SC1 by using the first setting data, and may sense the second memory plane MP2 under the second sensing condition SC2 by using the second setting data, but the embodiment is not limited thereto. There may be more various methods of sensing each memory plane.

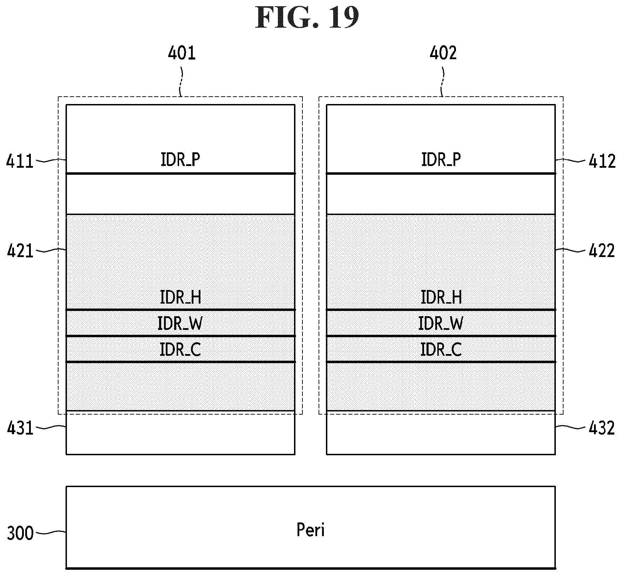

FIG. 19 is a view illustrating setting data according to one or more example embodiments.

Referring to FIG. 19, in the first memory plane 401 of the nonvolatile memory device, preceding setting data IDR_P may be stored in one region 411 belonging to the first region R1. In the memory plane 401 of the nonvolatile memory device, three following setting data IDR_H, IDR_W and IDR_C may be stored in another region 421 belonging to the second region R2. In the memory plane 401 of the nonvolatile memory device, user data may be stored in another region 431 belonging to the third region R3. In the replica memory plane 402 of the nonvolatile memory device, replica setting data of the preceding setting data IDR_P may be stored in one region 412 belonging to the first region R1. In the replica memory plane 402 of the nonvolatile memory device, replica setting data of the three following setting data IDR_H, IDR_W and IDR_C may be stored in another region 422 belonging to the second region R2. In the replica memory plane 402 of the nonvolatile memory device, user data may be stored in another region 432 belonging to the third region R3.

In this case, in S1040, the first setting data may be any one of the three following setting data IDR_H, IDR_W and IDR_C. The second setting data may be any one of the three following setting data IDR_H, IDR_W and IDR_C.

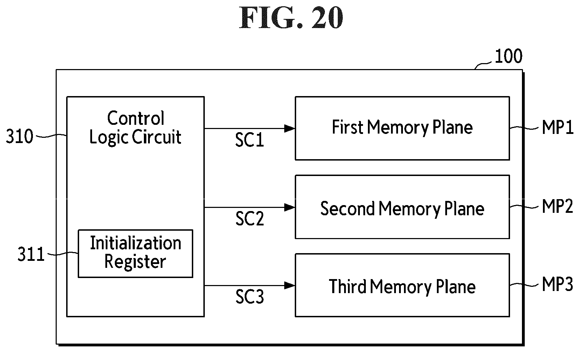

FIG. 20 is a view illustrating a method of sensing a memory block by a nonvolatile memory device according to one or more example embodiments.

Referring to FIG. 20, the nonvolatile memory device 100 may sense a memory plane by applying the same or different setting data to different memory planes. For example, the control logic circuit 310 of the nonvolatile memory device 100 may sense a first memory plane MP1, a second memory plane MP2 and a third memory plane MP3 under a first sensing condition SC1 based on initialization information and setting data stored in the initialization register 311, or may sense the first memory plane MP1 under the first sensing condition SC1, sense the second memory plane MP2 under a second sensing condition SC2 and sense the third memory plane MP3 under a third sensing condition SC3.

For example, the nonvolatile memory device may store at least one of the three following setting data IDR_H, IDR_W and IDR_C in the initialization register based on the initialization information. The first setting data may be any one of the three following setting data IDR_H, IDR_W and IDR_C. The second setting data may be any one of the three following setting data IDR_H, IDR_W and IDR_C. The third setting data may be any one of the three following setting data IDR_H, IDR_W and IDR_C.

The first setting data may include the first sensing condition SC1. The second setting data may include the second sensing condition SC2. The third setting data may include the third sensing condition SC3. Each sensing condition may include various operation variables used in the nonvolatile memory device. In this case, the operation variables of the second sensing condition SC2 may have values different from those of the first sensing condition SC1, and the operation variables of the third sensing condition SC3 may have values different from those of the first sensing condition SC1 and the second sensing condition SC2.

The first memory plane MP1 may include (store) a first data block. The second memory plane MP2 may include (store) a second data block. The third memory plane MP3 may include (store) a third data block. When the first data block, the second data block and the third data block belong to the first group, the control logic circuit 310 of the nonvolatile memory device 100 may sense the first memory plane MP1 to the third memory plane MP3 under the first sensing condition SC1 by using the first setting data stored in the initialization register 311. When the first data block belongs to the first group, the second data block belongs to the second group, and the third data block belongs to the third group, the control logic circuit 310 of the nonvolatile memory device 100 may sense the first memory plane MP1 under the first sensing condition SC1 by using the first setting data, sense the second memory plane MP2 under the second sensing condition SC2 by using the second setting data and sense the third memory plane MP3 under the third sensing condition SC3 by using the third setting data, but the embodiment is not limited thereto. There may be more various methods of sensing each memory plane.

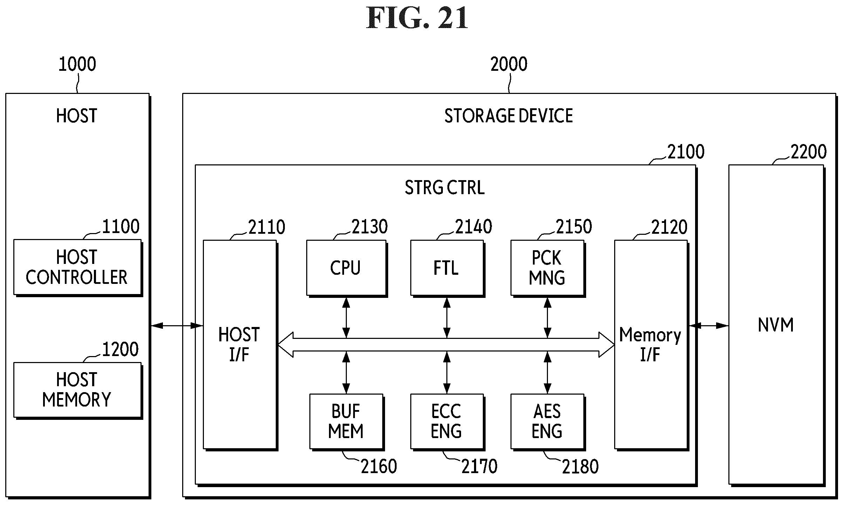

FIG. 21 is a block diagram illustrating a host-storage system that includes a storage device according to one or more example embodiments.

Referring to FIG. 21, the host-storage system may include a host 1000 and a storage device 2000. Also, the storage device 2000 may include a storage controller 2100 and a nonvolatile memory (NVM) 2200. Also, in accordance with an exemplary embodiment of the disclosure, the host 1000 may include a host controller 1100 and a host memory 1200. The host memory 1200 may serve as a buffer memory configured to temporarily store data to be transmitted to the storage device 2000 or data transmitted from the storage device 2000.

The storage device 2000 may include a storage medium configured to store data in accordance with a request from the host 1000. As an example, the storage device 2000 may include at least one of a solid state drive (SSD), an embedded memory, and a detachable external memory. When the storage device 2000 is the SSD, the storage device 2000 may be a device that complies with the standard of a nonvolatile memory express (NVMe). When the storage device 2000 is the embedded memory or the external memory, the storage device 2000 may be a device that complies with the standard of a universal flash storage (UFS) or an embedded multi-media card (eMMC). Each of the host 1000 and the storage device 2000 may generate and transmit packets according to a standard protocol that is employed.

When the nonvolatile memory (or a nonvolatile memory device) 2200 of the storage device 2000 includes a flash memory, the flash memory may include a two-dimensional (2D) NAND memory array or a three-dimensional (3D) (or vertical) NAND (VNAND) memory array. As another example, the storage device 2000 may include other various types of nonvolatile memories. For example, a magnetic random access memory (MRAM), a spin-transfer torque MRAM, a Conductive Bridging RAM (CBRAM), a Ferroelectric RAM (FeRAM), a Phase RAM (PRAM), a Resistive RAM and other various types of memories may be applied to the storage device 2000.

Each of the host controller 1100 and the host memory 1200 may be implemented as a separate semiconductor chip. Alternatively, the host controller 1100 and the host memory 1200 may be integrated into the same semiconductor chip. As an example, the host controller 1100 may be any of a plurality of modules provided in an application processor, and the application processor may be implemented as a system on chip (SoC). In addition, the host memory 1200 may be an embedded memory provided in the application processor, or may be a nonvolatile memory or memory module disposed outside the application processor.

The host controller 1100 may store data (e.g., write data) of a buffer region in the nonvolatile memory 2200, or may manage an operation of storing data (e.g., read data) of the nonvolatile memory 2200 in the buffer region.

The storage controller 2100 may include a host interface (I/F) 2110, a storage-memory interface 2120 and a central processing unit (CPU) 2130. The storage controller 2100 may further include a flash translation layer (FTL) 2140, a package (PCK) manger 2150, a buffer (BUF) memory 2160, an error correction code (ECC) engine 2170 and an advanced encryption standard (AES) engine 2180. The storage controller 2100 may further include a working memory (not shown) in which the flash translation layer (FTL) 2140 is loaded, and the CPU 2130 may control data write and read operations for the nonvolatile memory device 2200 by executing the flash translation layer 2140.

In detail, the storage device 2000 may receive a storage device driving signal from the host 1000 through the host interface 2110. The CPU 2130 may transmit an initialization command in response to the storage device driving signal. The initialization command may be transmitted to the nonvolatile memory device 2200 through the storage-memory interface 2120.

The host interface 2110 may transmit and receive packets to and from the host 1000. The packets transmitted from the host 1000 to the host interface 2110 may include a command or data to be written in the nonvolatile memory device 2200, and the packets transmitted from the host interface 2110 to the host 1000 may include a response to the command or data read from the nonvolatile memory device 2200. The storage-memory interface 2120 may transmit the data to be written in the nonvolatile memory device 2200 to the nonvolatile memory device 2200 or may receive the data read from the nonvolatile memory device 2200. Such a storage-memory interface 2120 may be implemented to comply with standard protocols such as Toggle or Open NAND Flash Interface (ONFI).

/////The flash translation layer 2140 may perform various functions such as address mapping, wear-leveling and garbage collection. The address mapping operation is an operation of changing a logical address received from the host 1000 to a physical address used to actually store data in the nonvolatile memory device 2200. The wear-leveling is a technique for preventing excessive degradation of a specific block by allowing blocks in the nonvolatile memory device 2200 to be used uniformly, and may exemplarily be implemented through firmware technology for balancing erase counts of physical blocks. The garbage collection is a technique for making sure of the available capacity in the nonvolatile memory device 2200 by copying valid data of a block to a new block and then erasing the existing block.

The packet manger 2150 may generate packets according to a protocol of an interface negotiated with the host 1000 or parse various kinds of information from the packets received from the host 1000. Also, the buffer memory 2160 may temporarily store data to be written in the nonvolatile memory device 2200 or data to be read from the nonvolatile memory device 2200.

The buffer memory 2160 may be provided in the storage controller 2100, or may be disposed outside the storage controller 2100.

The ECC engine 2170 may perform error detection and correction functions for the read data read from the nonvolatile memory device 2200. **In** more detail, the ECC engine 2170 may generate parity bits for write data to be written in the nonvolatile memory device 2200, and the generated parity bits may be stored in the nonvolatile memory device 2200 together with the write data. When reading the data from the nonvolatile memory device 2200, the ECC engine 2170 may correct an error of the read data by using the parity bits read from the nonvolatile memory device 2200 together with the read data, and then may output the error-corrected read data.

The AES engine 218 may perform at least one of an encryption operation and a decryption operation for the data input to the storage controller 2100 by using a symmetric-key algorithm.

According to some embodiments, the host 1000 may correspond to the host 10 of FIG. 1. The storage device 2000 may correspond to the storage device 20 of FIG. 1. The storage controller 2100 may correspond to the memory controller 200 of FIG. 1. The nonvolatile memory device 2200 may correspond to the nonvolatile memory device 100 of FIG. 1.

According to some embodiments, the storage controller 2100 may classify a portion of a plurality of data blocks of the nonvolatile memory device 2200 into a first group. The storage controller 2100 may classify another portion different from the portion classified into the first group of the plurality of data blocks of the nonvolatile memory device 2200 into a second group. The storage controller 2100 may determine first setting data required for sensing the data blocks included in the first group, based on environment information. The storage controller 2100 may determine second setting data required for sensing the data blocks included in the second group, based on the environment information. The storage controller 2100 may store initialization information on the determined setting data in the memory device.

According to some embodiments, the nonvolatile memory device 2200 may include a memory cell array including (storing) a first data block and a second memory plane including (storing) a second data block, and a control logic circuit for writing or reading data in or from the memory cell array. The memory cell array may store first initialization information for determining setting data including a sensing condition for sensing each data block, first setting data including a first sensing condition, and second setting data including a second sensing condition. The control logic circuit may perform a metadata open operation in response to an initialization command. The control logic circuit may store the first setting data and the second setting data in an initialization register. The control logic circuit may sense the first memory plane under the first sensing condition and sense the second memory plane under the second sensing condition in accordance with the first initialization information. The control logic circuit may receive second initialization information for determining setting data including the sensing condition for sensing each data block from the memory controller, and update the first initialization information based on the second initialization information.

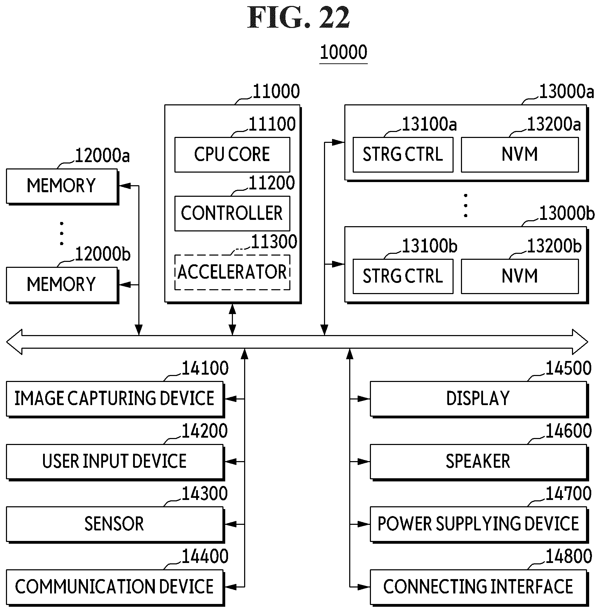

FIG. 22 is a block diagram illustrating a system to which a storage device is applied according to one or more example embodiments.

The system (or electronic system) 10000 of FIG. 22 may be a mobile system such as a mobile communication terminal (e.g., mobile phone), a smartphone, a tablet personal computer (PC), a wearable device, a healthcare device, or an Internet of things (IOT) device. However, the system 10000 of FIG. 22 is not necessarily limited to the mobile system, and may be a personal computer, a laptop computer, a server, a media player, or an automotive device (e.g., a navigator).

Referring to FIG. 22, the system 10000 may include a main processor 11000, memories (e.g., 12000a and 12000b), and storage devices (e.g., 13000a and 13000b). The system 10000 may further include at least one of an image capturing device 14100, a user input device 14200, a sensor 14300, a communication device 14400, a display 14500, a speaker 14600, a power supplying device 14700 and a connecting interface 14800.

The main processor 11000 may control the overall operation of the electronic system 10000, in more detail the operation of other elements constituting the electronic system 10000. The main processor 11000 may be implemented as a general purpose processor, a dedicated processor, or an application processor.

The main processor 11000 may include one or more CPU cores 11100, and may further include a controller 11200 configured to control the memories 12000a and 12000b and/or the storage devices 13000a and 13000b. In some embodiments, the main processor 11000 may further include an accelerator 11300 that is a dedicated circuit for highspeed data computation such as artificial intelligence (AI) data computation. The accelerator 11300 may include a graphics processing unit (GPU), a neural network processing unit (NPU), and/or a data processing unit (DPU), and may be implemented as a separate chip physically separated from other elements of the main processor 11000.

The memories 12000a and 12000b may be used as main memory devices of the system 10000, and may include a volatile memory such a static random access memory (SRAM) and/or a dynamic random access memory (DRAM), but may also include a nonvolatile memory such as a flash memory, a phase-change RAM (PRAM) and/or a resistive PRAM. The memories 12000a and 12000b may be implemented in the same package as the main processor 11000.

The storage devices 13000a and 13000b may be nonvolatile storage devices for storing data regardless of whether power is supplied, and may have a storage capacity greater than that of the memories 12000a and 12000b. The storage devices 13000a and 13000b may include storage controllers (STRG CTRL) 13100a and 13100b and nonvolatile memories (NVM) 13200a and 13200b configured to store data under the control of the storage controllers 1310a and 1310b. The nonvolatile memories 13200a and 13200b may include a flash memory having a two-dimensional (2D) structure or a three-dimensional (3D) Vertical NAND (V-NAND) structure, but may also include other types of nonvolatile memories such as a PRAM and/or an RRAM.

The storage devices 13000a and 13000b may be included in the system 10000 in a physically separated state from the main processor 11000, and may be implemented in the same package as the main processor 11000. In addition, the storage devices 13000a and 13000b may have a type of a solid state drive (SSD) or a memory card, and may be detachably coupled to other elements of the system 10000 through an interface, such as the connecting interface 1480 that will be described later. Such storage devices 13000a and 13000b may be, but are not limited to, devices to which standard protocols such as Universal Flash Storage (UFS), embedded Multi-Media Card (eMMC), or Nonvolatile Memory express (NVMe) are applied.

The image capturing device 14100 may capture a still image or a video. The image capturing device 14100 may include a camera, a camcorder and/or a webcam.

The user input device 14200 may receive various types of data input from a user of the system 10000, and may include a touch pad, a keypad, a keyboard, a mouse and/or a microphone.

The sensor 14300 may sense various types of physical quantities that may be acquired from the outside of the system 10000, and may convert the sensed physical quantities into an electrical signal. The sensor 14300 may include a temperature sensor, a pressure sensor, an illuminance sensor, a position sensor, an acceleration sensor, a biosensor and/or a gyroscope sensor.

The communication device 14400 may perform transmission and reception of signals between other devices outside the system 10000 in accordance with various communication protocols. The communication device 14400 may include an antenna, a transceiver and/or a modem.

The display 14500 and the speaker 14600 may serve as output devices configured to output visual information and auditory information to a user of the system 10000, respectively.

The power supplying device 14700 may appropriately convert power supplied from an external power source and/or a battery (not shown) embedded in the system 10000 to supply the converted power to each element of the system 10000.

The connecting interface 14800 may provide connection between the system 10000 and an external device connected to the system 10000 to transmit and receive data to and from the system 10000. The connecting interface 14800 may be implemented in a variety of interface modes such as Advanced Technology Attachment (ATA), Serial ATA (SATA), external SATA (e-SATA), Small Computer Small Interface (SCSI), Serial Attached SCSI (SAS), Peripheral Component Interconnection (PCI), PCI express (PCIe), NVM express (NVMe), IEEE 1394, universal serial bus (USB) interface, Secure Digital (SD) card interface, Multi-Media Card (MMC) interface, embedded multi-media card (eMMC) interface, Universal Flash Storage (UFS) interface, embedded Universal Flash Storage (eUFS) interface, and Compact Flash (CF) card interface. According to some embodiments, the main processor 11000 may correspond to the host 10 of FIG. 1. Each of the storage devices 13000a and 13000b may correspond to the storage device 20 of FIG. 1.

## Claims

1. A memory controller (200) comprising a processing circuit (210) configured to control a memory device (50) including a plurality of data blocks (DB),
wherein the processing circuit (210) is further configured to:
classify a first portion of the plurality of data blocks (DB) into a first group (GR1);
classify a second portion of the plurality of data blocks (DB) into a second group (GR2), the second portion being different from the first portion;
determine, based on environment information, first setting data to be used for sensing data blocks included in the first group (GR1);
determine, based on the environment information, second setting data to be used for sensing data blocks included in the second group (GR2); and
store initialization information on the determined first setting data and second setting data in the memory device (50).

2. The memory controller (200) of claim 1, wherein the plurality of data blocks are included in a first level memory cell, and a second level memory cell that stores a larger number of bits of data per cell than the first level memory cell, and
wherein the processing circuit (210) is further configured to classify data blocks included in the first level memory cell into the first group (GR1), and classify data blocks included in the second level memory cell into the second group (GR2).

3. The memory controller (200) of claim 1, wherein the processing circuit (210) is further configured to classify data blocks allocated to a first application among the plurality of data blocks into the first group (GR1), and classify data blocks allocated to a second application different from the first application among the plurality of data blocks into the second group (GR2).

4. The memory controller (200) of claim 1, wherein the processing circuit (210) is further configured to classify data blocks included in a first memory die of the memory device (50) among the plurality of data blocks into the first group (GR1), and classify data blocks included in a second memory die of the memory device (50) among the plurality of data blocks into the second group (GR2), the first memory die being different from the second memory die.

5. The memory controller (200) of any one of claims 1 to 4, wherein the processing circuit (210) is further configured to receive workload information on the plurality of data blocks from the memory device (50), and re-classify the plurality of data blocks into the first group (GR1) and the second group (GR2) based on the workload information.

6. The memory controller (200) of claim 5, wherein the processing circuit (210) is further configured to update the environment information based on the workload information.

7. The memory controller (200) of any one of claims 1 to 6, wherein the environment information includes a first retention parameter of the data blocks included in the first group (GR1) and a second retention parameter of the data blocks included in the second group (GR2).

8. The memory controller (200) of claim 7, wherein the first retention parameter includes information on a retention request value for each of the data blocks included in the first group (GR1), and
wherein the second retention parameter includes information on a retention request value for each of the data blocks included in the second group (GR2).

9. The memory controller (200) of any one of claims 1 to 8, wherein the environment information includes a first durability parameter of the data blocks included in the first group (GR1) and a second durability parameter of the data blocks included in the second group (GR2).

10. The memory controller (200) of claim 9, wherein the first durability parameter includes at least one of an erase count information and a program-erase cycle information for each of the data blocks included in the first group (GR1), and
wherein the second durability parameter includes at least one of an erase count information and a program-erase cycle information for each of the data blocks included in the second group (GR2).

11. The memory controller (200) of any one of claims 1 to 10, wherein the processing circuit (210) is further configured to:
classify a third portion of the plurality of data blocks into a third group (GR3), the third portion being different from the first portion and the second portion; and
determine third setting data to be used for sensing data blocks included in the third group (GR3) based on the environment information.

12. A storage device (20) comprising:
a memory device (50) including data blocks belonging to a first group (GR1) and data blocks belonging to a second group (GR2); and
a memory controller (200) configured to control the memory device (50),
wherein the memory controller (200) is according to any one of claims 1 to 11,
wherein the first setting data include a first sensing condition to be used for sensing the data blocks belonging to the first group (GR1),
wherein the second setting data include a second sensing condition to be used for sensing the data blocks belonging to the second group (GR2),
wherein the memory controller (200) is configured to provide the initialization information on the determined first setting data and second setting data to the memory device (50), and
wherein the memory device (50) is configured to:
perform a setting operation in response to an initialization command of the memory controller (200);
sense the data blocks belonging to the first group (GR1) under the first sensing condition based on the initialization information; and
sense the data blocks belonging to the second group (GR2) under the second sensing condition based on the initialization information.

13. The storage device (20) of claim 12, wherein the memory device (50) includes a first level memory cell and a second level memory cell that stores a larger number of bits of data per cell than the first level memory cell, and
wherein the data blocks belonging to the first group (GR1) include data blocks included in the first level memory cell, and
wherein the data blocks belonging to the second group (GR2) include data blocks included in the second level memory cell.

14. The storage device of claim 12, wherein the data blocks belonging to the first group (GR1) include data blocks allocated to a first application, and
wherein the data blocks belonging to the second group (GR2) include data blocks allocated to a second application different from the first application.

15. A method of operating a memory controller (200), the method comprising:
classifying, by the memory controller (200), a plurality of data blocks (DB) included in a memory device (50) into a first group (GR1) and a second group (GR2);
based on environment information, determining, by the memory controller (200), first setting data to be used for sensing the data blocks belonging to the first group (GR1);
based on the environment information, determining, by the memory controller (200), second setting data to be used for sensing the data blocks belonging to the second group (GR2); and
providing, by the memory controller (200), initialization information on the first setting data and the second setting data determined for each group, to the memory device (50).
